# FASCICULE DE BREVET EUROPEEN

(11) **EP 0 908 944 B1**
(45) Date de publication et mention de la délivrance du brevet: **30.11.2011**
(21) Numéro de dépôt: 98402488.5
(22) Date de dépôt: 07.10.1998
(51) Int. Cl.: H01L 21/66

(54) **Caractérisation électrique d'une couche isolante recouvrant un substrat conducteur ou semiconducteur**
Elektrische Charakterisierung einer Isolierschicht, die ein leitendes oder halbleitendes Substrat bedeckt
Electrical characterisation of an insulating layer on a conductive or semiconductive substrate

(30) Priorité: 09.10.1997 FR 9712604
(43) Date de publication de la demande: 14.04.1999
(73) Titulaire: Commissariat à l'Énergie Atomique et aux Énergies Alternatives, 75015 Paris (FR)
(72) Inventeur: Henaux, Stéphane, 38100 Grenoble (FR)
(74) Mandataire: Poulin, Gérard

(56) Documents cités:
- EP-A- 0 581 703
- WO-A-96/23319
- WANG H ET AL: "AN OPTIMIZED GATE OXIDE BREAKDOWN TEST BY ACTIVATING OXIDE TRAPS ATLOW FIELDS" INTERNATIONAL ELECTRON DEVICES MEETING 1992, SAN FRANCISCO, DEC. 13 - 16, 1992, 13 décembre 1992, INSITUTE OF ELECTRICAL AND ELECTRONICS ENGINEERS, pages 143-146, XP000687397
- PATENT ABSTRACTS OF JAPAN vol. 015, no. 037 (P-1159), 29 janvier 1991 & JP 02 275364 A (MATSUSHITA ELECTRIC WORKS LTD), 9 novembre 1990,
- "CHARACTERIZING WEAK SPOTS IN DIELECTRIC LAYERS" IBM TECHNICAL DISCLOSURE BULLETIN, vol. 34, no. 4B, 1 septembre 1991, pages 98-99, XP000189506
- PATENT ABSTRACTS OF JAPAN vol. 012, no. 402 (E-673), 25 octobre 1988 & JP 63 142826 A (TOKYO ELECTRON LTD), 15 juin 1988,

## Description

### Domaine technique

La présente invention concerne un procédé de caractérisation électrique d'une couche isolante recouvrant un substrat conducteur ou semiconducteur. Elle concerne également un dispositif pour la mise en oeuvre de ce procédé de caractérisation.

### Etat de la technique

Dans le domaine des semiconducteurs en particulier, on est souvent amené à vérifier la qualité d'une couche isolante déposée sur un substrat semiconducteur. A titre d'exemple, l'oxyde de grille est un élément essentiel des circuits intégrés MOS (Metal Oxide Semiconductor). La qualité de cet oxyde dépend énormément du substrat semiconducteur de départ.

Il est donc avantageux de prévoir la qualité d'oxyde de grille d'un dispositif MOS à réaliser sur un type de substrat donné sans avoir à fabriquer ce dispositif. Un procédé connu pour parvenir à ce résultat consiste à déposer une couche d'oxyde (dite oxyde mince par la suite) du même type que l'oxyde de grille désiré sur toute une face (ou face avant) d'un substrat témoin et à tester électriquement cet oxyde mince entre un contact avant et un contact arrière. Le contact arrière est habituellement un plateau métallique conducteur placé sur la face arrière du substrat témoin. La fabrication du contact avant ne doit pas dégrader l'oxyde mince déposé sur la face avant du substrat. Ce contact avant possède une aire de contact donnée qui définit la portion d'oxyde testée.

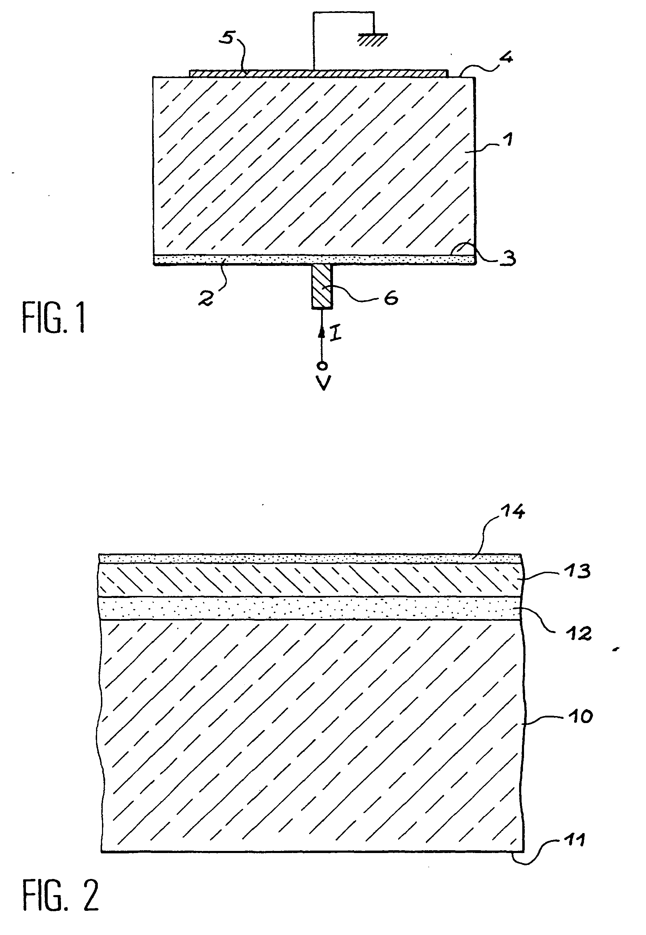

Les sondes à mercure permettent de réaliser les deux contacts. De nombreux appareils ont été commercialisés. La figure 1 illustre le principe mis en oeuvre appliqué à un substrat de silicium 1 recouvert d'une couche de silice 2 sur sa face avant 3. Le contact avec la face arrière 4 du substrat 1 est réalisé par un plateau métallique 5 relié à la masse. Le contact avant, avec la face libre de l'oxyde mince 2, est réalisé par une électrode au mercure 6 qui permet d'appliquer une tension V par rapport à la masse.

Le test le plus simple consiste à détecter les défauts majeurs, c'est-à-dire les courts-circuits locaux de l'oxyde mince. Ces courts-circuits sont par exemple dus à une excroissance de silicium faisant saillie depuis le substrat. Le test se déroule en promenant l'électrode au mercure sur la face libre de l'oxyde mince 2. Si le contact avant est placé sur une portion d'oxyde contenant un défaut majeur, on mesure un courant de fuite I dès les faibles valeurs de la tension V.

On peut aussi étudier les défauts mineurs éventuellement présents dans la portion d'oxyde étudiée. Pour cela, on augmente progressivement la tension V à partir de zéro et en relevant la valeur V_{bd} pour laquelle le courant I se met brusquement à augmenter. La valeur V_{bd} est appelée tension de claquage de l'oxyde mince dans la portion d'oxyde testé.

Dans le test précédent, la couche isolante était disposée sur un matériau semiconducteur formant un substrat dont la face arrière recevait le contact arrière. Un tel test s'avère impossible à effectuer dans certains cas, par exemple sur un substrat SOI (silicium sur isolant) tel que le montre la figure 2. Ce substrat comprend une masse 10 en silicium, constituant le substrat initial et possédant une face arrière 11. Sur la face opposée, on a fait croître une couche d'oxyde 12, dite couche d'oxyde enterrée, puis on rapporte une couche de silicium 13. Ce substrat SOI ainsi constitué est ensuite recouvert d'une couche mince d'oxyde 14, dite oxyde mince, qu'il faut tester. On comprend qu'une telle structure ne peut être testée comme précédemment, l'oxyde enterré 12 s'opposant au passage du courant entre l'oxyde mince 14 et la face arrière 11 même si un défaut existe dans la portion d'oxyde mince testée.

Une solution possible serait de faire la mesure entre deux contacts sur la face libre de l'oxyde mince 14. Une première méthode consisterait à conserver l'oxyde mince sur toute la surface du substrat. Dans ce cas, un courant I important ne serait mesuré que si l'oxyde mince présente un défaut dans chacune des deux portions d'oxyde contactées. Un défaut présent dans l'une des deux portions ne serait pas détecté si l'autre portion d'oxyde était intacte.

Une deuxième méthode consisterait à éliminer localement l'oxyde mince de manière à poser l'un des deux contacts avant sur le film de silicium. Cela représente une étape technologique, qui peut dégrader l'oxyde mince à tester. De plus, il est très difficile de distinguer optiquement les zones couvertes d'oxyde mince et les zone non couvertes, car l'oxyde mince est pratiquement transparent. Le positionnement des contacts serait donc délicat.

Le document « Characterizing weak spots in dielectric layers », IBM Technical Disclosure Bulletin, vol. 34, n°4B, 1er septembre 1991, pages 98 et 99, XP 000189506, divulgue un procédé de caractérisation électrique d'une couche isolante recouvrant un substrat semiconducteur. Le procédé est utilisé sur des substrats servant d'échantillons, une fois que la couche isolante a été formée. Le procédé comprend les étapes suivantes : le traitement de surface de la couche d'oxyde pour permettre une meilleure détection des défauts, le dépôt de plots d'aluminium, le recuit des plots, la mesure de la tension de claquage.

Le document « An optimized gate oxide breakdown test by activating oxide traps at low fields » de H. Wang et al., International Electron Devices Meeting 1992, San Francisco, 13 décembre 1992, pages 143 à 146, XP 000687397 IEEE, décrit un test de claquage de l'oxyde de grille d'un dispositif semiconducteur. Le claquage est obtenu en faisant croître le courant traversant l'oxyde de grille soumis à une tension électrique.

Le document WO-A-96/23319 concerne la caractérisation électrique d'une couche d'oxyde déposée sur un substrat semiconducteur. On procède à une mesure de courant de fuite dans la couche d'oxyde en appliquant une tension entre une zone de la surface libre de la couche d'oxyde et le substrat semiconducteur sous-jacent qui est donc directement accessible. La mesure se fait en deux emplacements, les zones de couche d'oxyde testées étant de surfaces différentes.

### Exposé de l'invention

Afin de remédier à ce problème, la présente invention propose une solution dont le principe de base est le suivant. On crée d'abord artificiellement, dans la couche isolante à tester, un défaut majeur formant court-circuit sous l'un des contacts du dispositif de mesure. On effectue ensuite un test de conduction électrique entre le contact placé sur le défaut majeur et un autre contact de test placé sur la portion de couche isolante à tester.

L'invention a donc pour objet un procédé de caractérisation d'une couche isolante selon la revendication indépendante 1. D'autres modes de réalisation de l'invention sont définis dans les revendications dépendantes 2 à 5.

Une application particulièrement intéressante de l'invention concerne un substrat semiconducteur comprenant une couche isolante enterrée et une couche isolante superficielle qui est la couche isolante à tester. Ce substrat semiconducteur peut notamment être un substrat dit Silicium-Sur-Isolant où la couche enterrée est une couche d'oxyde de silicium et où la couche isolante superficielle est également une couche d'oxyde de silicium. Avantageusement, selon un exemple ne faisant pas partie de la présente invention, le silicium sous-jacent à la couche d'oxyde superficielle est maintenu sous forte illumination pendant l'application du test électrique afin d'y favoriser la génération de porteurs minoritaires. Une autre façon de favoriser la génération de porteurs minoritaires, selon un exemple ne faisant pas partie de la présente invention, consiste à porter le silicium sous-jacent à la couche d'oxyde superficielle à une température supérieure à la température ambiante pendant l'application du test électrique.

Selon un exemple ne faisant pas partie de la présente invention un dispositif convenant à la caractérisation d'une couche isolante dont une première face recouvre une face conductrice ou semiconductrice d'un substrat, la seconde face de la couche isolante étant accessible électriquement, la caractérisation consistant à vérifier la qualité d'isolation électrique présentée par au moins une zone de la couche isolante au moyen d'un test électrique, comprend :
- des moyens pour créer au moins un défaut majeur dans une zone de la couche isolante, ce défaut majeur formant un court-circuit localisé entre la seconde face de la couche isolante et ladite face conductrice ou semiconductrice du substrat,
- des moyens pour appliquer le test électrique à la zone de la couche isolante à tester grâce à un signal électrique fourni entre une électrode apte à être mise en contact avec ledit défaut majeur et une électrode apte à être mise en contact avec ladite zone à tester.

Le dispositif peut comprendre au moins trois électrodes aptes à être mises en contact avec la seconde face de la couche isolante, deux de ces électrodes servant à appliquer une tension de claquage à la couche isolante afin d'y créer deux défauts majeurs, la troisième électrode servant, avec l'une au moins des deux autres électrodes, à appliquer ledit test électrique.

Les moyens pour créer au moins un défaut majeur peuvent aussi être des moyens mécaniques opérant par traversée de la couche isolante.

L'électrode servant conjointement à appliquer la tension de claquage et le test électrique peut présenter une aire de contact annulaire, l'électrode apte à être mise en contact avec la zone à tester étant centrée sur l'aire de contact annulaire.

Les électrodes d'application du test électrique peuvent être des électrodes au mercure.

Avantageusement, les moyens pour appliquer le test électrique fournissent un signal électrique en forme de rampe entre le défaut majeur et ladite zone à tester.

De préférence, les moyens pour appliquer le test électrique comprennent des moyens permettant d'accéder à la mesure du courant pouvant circuler entre les électrodes permettant l'application du test électrique.

### Brève description des figures

L'invention sera mieux comprise et d'autres avantages et particularités apparaîtront dans la description qui va suivre, donnée à titre d'exemple non limitatif, accompagnée des dessins annexés parmi lesquels :
- la figure 1 est illustrative d'un procédé de caractérisation électrique d'une couche de silice recouvrant un substrat de silicium, selon l'art connu,
- la figure 2 représente un substrat du type Silicium-Sur-Isolant recouvert d'une couche d'oxyde de silice,
- la figure 3 est illustrative du procédé de caractérisation électrique selon la présente invention appliqué à un substrat du type représenté à la figure 2,

- les figures 4, 5 et 6 représentent des courbes courant-tension,
- la figure 7 montre une disposition d'électrodes pour dispositif de caractérisation selon un exemple ne faisant pas partie de la présente invention,
- la figure 8 montre, de manière détaillée, une prise de contact électrique entre une électrode et une couche isolante d'épaisseuer variable.

### Description détaillée de modes de réalisation de l'invention

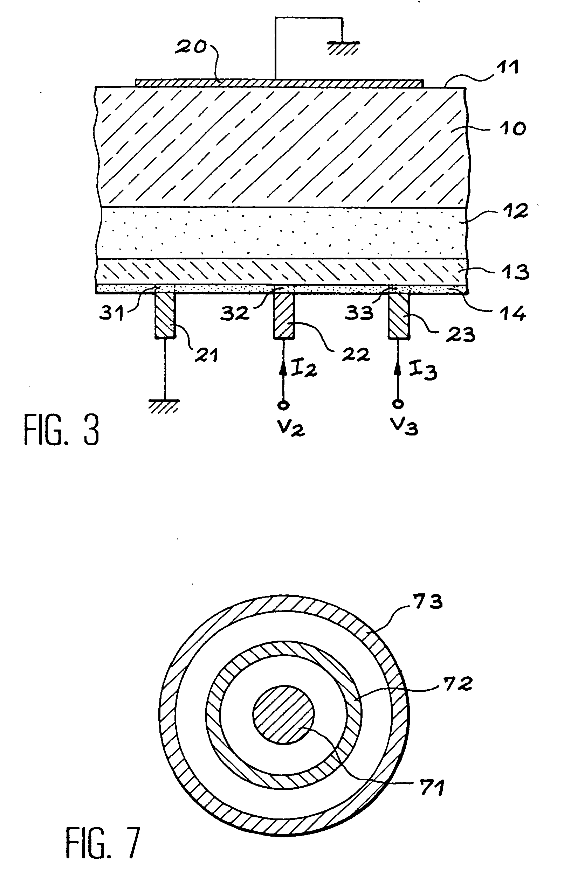

La figure 3 illustre le procédé selon la présente invention au cas du substrat représenté à la figure 2. Le dispositif de caractérisation utilisé comprend une sonde à mercure à trois contacts ou plus. La face arrière 11 est mise à la masse grâce à une électrode plateau 20. La face de l'oxyde mince opposée à la face qui est en contact avec la couche de silicium 13 et qui a une épaisseur comprise entre 3 et 1000 nm, est mise au contact de trois électrodes au mercure 21, 22 et 23.

On va d'abord réaliser des défauts majeurs dans l'oxyde mince 14 par claquage électrique. Pour cela, l'électrode 21 est mise à la masse, l'électrode 22 est laissée à un potentiel flottant et une forte tension V₃ est appliquée à l'électrode 23, par exemple - 100 V. On obtient dans l'oxyde mince, en vis-à-vis des électrodes 21 et 23, des portions d'oxyde respectivement 31 et 33 contenant chacune un défaut majeur. La mesure du courant I₃ circulant entre les électrodes 21 et 23, via la couche de silicium 13, permet de s'assurer que des défauts majeurs ont bien été créés. Le courant I₃ est par exemple supérieur à 1 mA.

On peut ensuite procéder à l'application du test électrique pour la portion d'oxyde mince 32 située en vis-à-vis de l'électrode 22. Pour cela on applique une rampe de tension V₂ à l'électrode 22, l'électrode 23 étant mise à la masse, comme le sont l'électrode plateau 20 et l'électrode 21.

S'il y a un défaut majeur dans la portion d'oxyde 32, le courant I₂ transitant par l'électrode 22 augmente fortement dès les très faibles valeurs de V₂. S'il n'y a pas de défaut majeur mais seulement un défaut mineur ou aucun défaut, le courant I₂ est d'abord très faible et ne se met à augmenter brusquement qu'à partir d'une certaine valeur de V₂ appelée tension de claquage V_{bd}.

Selon un exemple ne faisant pas partie de la présente invention, la face avant du substrat est maintenue sous forte illumination durant la mise en oeuvre du procédé. Le but de cette illumination est de maximiser le courant dans les défauts majeurs qui peuvent être décrits simplement comme des jonctions Schottky mercure-silicium. Lorsqu'une telle jonction est polarisée en direct, elle ne s'oppose pas au passage du courant. En revanche, lorsqu'elle est polarisée en inverse, elle ne laisse passer qu'un faible courant appelé courant de fuite. La lumière favorise la génération de porteurs minoritaires et maximise le courant de fuite dans la ou les jonctions qui sont en inverse.

Une autre solution selon un exemple ne faisant pas partie de la présente invention, pour maximiser le courant dans les défauts majeurs consiste à augmenter la température au niveau des défauts majeurs sous les électrodes 21 et 23.

L'illumination du substrat côté face avant peut se faire sans problème si le porte-substrat, dans lequel sont percés les canaux à mercure verticaux pour les électrodes 21, 22 et 23, est en matière transparente. L'illumination doit être suffisamment forte pour augmenter le courant de fuite de manière significative. On peut utiliser une lampe halogène (blanche) de 100 W focalisée sur moins de 1 cm².

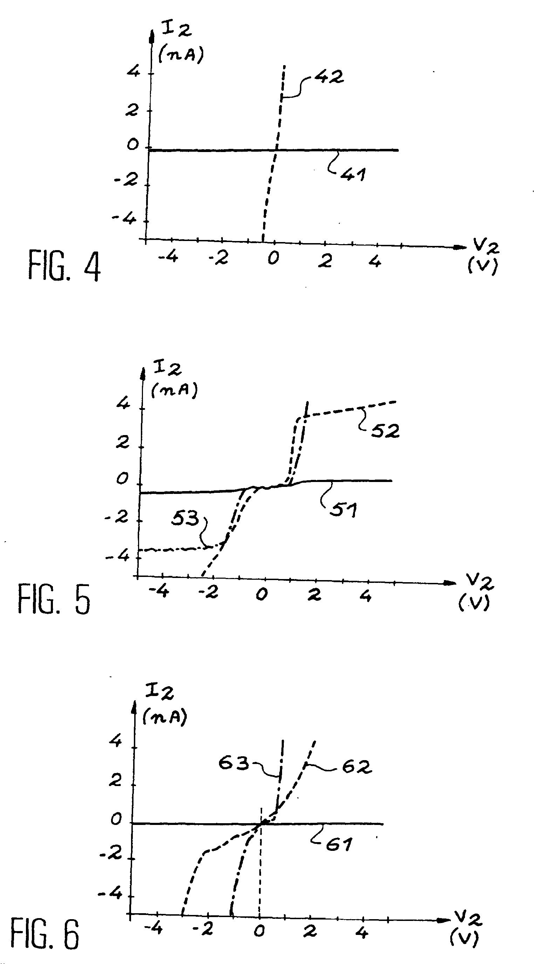

Les diagrammes des figures 4, 5 et 6 donnent des exemples de résultats obtenus sur différents substrats SOI. Ces diagrammes portent en ordonnées le courant I₂ en nA et en abscisses la tension V₂ en volts.

Le diagramme de la figure 4 présente des résultats obtenus pour un oxyde mince de 15 nm d'épaisseur recouvrant un substrat SOI, le silicium sous-jacent ayant un dopage de type n à raison de 10¹⁷ atomes/cm³. La courbe 41 est représentative de sites intacts. La courbe 42 correspond à un site présentant un défaut majeur.

Le diagramme de la figure 5 présente des résultats obtenus pour un oxyde mince de 7,5 nm d'épaisseur recouvrant un substrat SOI, le silicium sous-jacent n'étant pas dopé. La courbe 51 est représentative de sites intacts. Les courbes 52 et 53 correspondent à des sites présentant un défaut majeur.

Le diagramme de la figure 6 présente des résultats obtenus pour un oxyde mince de 15 nm d'épaisseur recouvrant un substrat SOI, le silicium sous-jacent n'étant pas dopé. La courbe 61 est représentative de sites intacts. Les courbes 62 et 63 correspondent à des sites présentant un défaut majeur.

Comme on le voit, le procédé selon l'invention s'applique à des substrats SOI dopés ou non. Les substrats dopés donnent des courants plus importants sur les portions d'oxyde défectueuses car le film de silicium sous-jacent à l'oxyde est moins résistif.

Le procédé selon l'invention peut être étendu à des dispositifs de caractérisation (ou sondes) ayant plus de trois électrodes au mercure. Chaque électrode supplémentaire permet de tester une portion d'oxyde de plus en chaque site. Par exemple, une sonde à quatre électrodes au mercure permet de tester l'oxyde mince en deux portions. Si de plus ces deux contacts sont de surfaces différentes, on peut faire des études de défectivité en fonction de la surface de test.

La forme des électrodes au mercure n'a pas une importance décisive. Une possibilité intéressante est de donner à l'électrode servant à créer le défaut majeur la forme d'un anneau entourant la zone de test. La figure 7 montre une telle disposition. On trouve, disposées concentriquement, une électrode de test centrale 71, une première électrode 72 pour obtenir un premier défaut majeur par claquage et une deuxième électrode 73 pour obtenir un deuxième défaut majeur par claquage.

Le fait d'avoir toujours la même distance entre l'électrode de test et l'électrode servant à créer un défaut majeur est un avantage car on maintient la plus constante possible la résistance de la portion de silicium située entre les deux électrodes. Ceci assure une bonne homogénéité des tests.

Le procédé selon la présente invention peut être mis en oeuvre en utilisant des contacts conducteurs solides (plots métalliques, dépôts de polymère conducteurs), obtenus selon les cas par évaporation, dépôt et gravure, ou par tout autre méthode ne dégradant pas l'oxyde mince à tester. Cependant, le coût et le temps de réalisation de ces contacts conducteurs peuvent être un obstacle à leur mise en oeuvre.

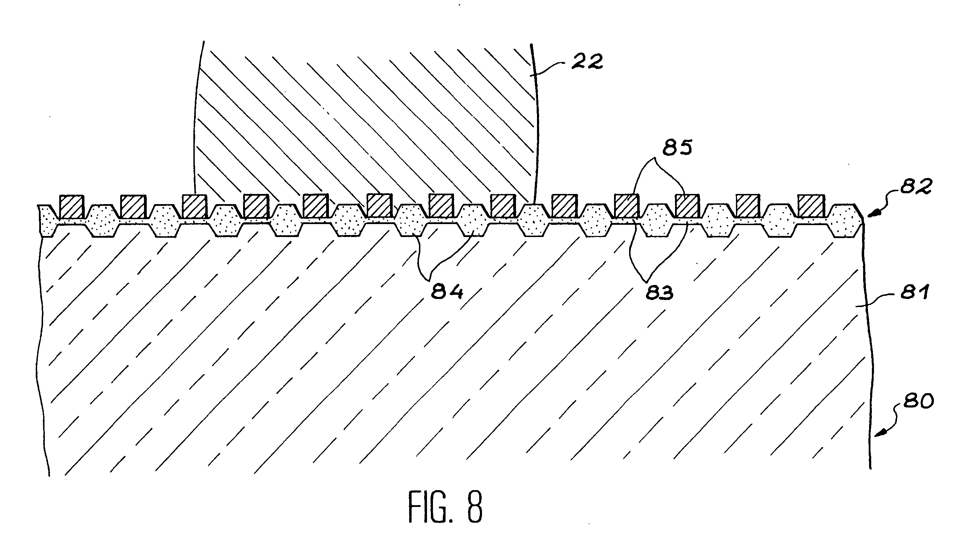

La couche isolante à caractériser peut présenter une face libre ou être recouverte d'une structure fournissant un accès électrique à cette couche comme le montre la figure 8. Cette figure montre un détail très agrandi d'un substrat en cours de caractérisation. Le substrat 80 comporte une partie 81 conductrice ou semiconductrice recouverte d'une couche isolante 82 présentant des variations d'épaisseur. Par exemple, si la partie 81 est en silicium, la couche isolante 82 peut être une couche d'oxyde de silicium comprenant des portions 83 de relativement faible épaisseur séparées par des portions 84 d'oxyde de type LOCOS d'épaisseur plus importante. Sur des portions 83, et entre les portions 84, sont disposés des plots conducteurs 85, par exemple en silicium polycristallin. Les électrodes du dispositif de caractérisation, par exemple l'électrode de mercure 22, peuvent alors assurer un contact électrique avec les portions 83 de faible épaisseur de la couche d'oxyde par l'intermédiaire des plots conducteurs 85.

L'invention s'applique bien sûr à d'autres substrats que les substrats SOI, par exemple à des substrats SiC sur isolant.

La présente invention se prête à différentes variantes d'exécution. Par exemple, une même électrode peut servir à former plusieurs défauts majeurs, ce qui permet de faire circuler un courant plus élevé.

Le test électrique peut consister à appliquer une tension alternative à la zone à tester et, à partir de la mesure du courant alternatif circulant, à déterminer l'impédance de la couche isolante (par exemple de la couche d'oxyde de silicium) et du matériau sous-jacent (par exemple le silicium) par analyse de sa phase et de son amplitude. La qualité de l'oxyde peut s'exprimer sous forme d'une mesure de résistance et capacité, de conductance et de capacité, de self et de résistance, de self et d'impédance.

On peut appliquer à la zone à tester une tension variant suivant une rampe, suivant un escalier ou de façon impulsionnelle. On peut par exemple appliquer une tension et mesurer le courant I jusqu'à ce que la tension devienne nulle et la durée t requise pour obtenir une tension nulle. On applique une autre tension plus élevée et on mesure le courant et la durée requise pour obtenir une tension nulle et ainsi de suite. On peut ensuite, pour chaque intervalle, calculer la quantité Ixt, ceci jusqu'au claquage. On peut ensuite déterminer la charge de claquage Q_{bd} = ΣIxt.

Comme il a été dit plus haut, on peut effectuer le test électrique en mesurant le courant circulant entre les électrodes. Au lieu de faire une mesure de courant, on peut faire une mesure de tension. La tension peut être asservie de façon que le courant obtenu reste constant. On relève le temps au bout duquel l'oxyde claque et on calcule le produit courant X temps pour déterminer Q_{bd} qui est la charge passée dans l'oxyde pendant ce temps. La valeur de Q_{bd} permet de caractériser l'oxyde.

## Revendications

1. Procédé de caractérisation d'une couche isolante (14) dont une première face recouvre et est en contact avec une face conductrice ou semiconductrice d'un substrat, la seconde face de la couche isolante (14) opposée à la première face, étant accessible électriquement, la caractérisation consistant à vérifier la qualité d'isolation électrique présentée par au moins une première zone (32) de la couche isolante (14) au moyen d'un test électrique, **caractérisé en ce qu'**il comprend les étapes de :
- création, par claquage de la couche isolante au moyen d'une tension électrique ou par traversée mécanique de la couche isolante, d'au moins un défaut majeur dans une seconde zone (31,33) de la couche isolante (14), la seconde zone étant différente de la première zone, ce défaut majeur formant un court-circuit localisé entre la seconde face de la couche isolante et ladite face conductrice ou semiconductrice du substrat,
- application du test électrique à la zone (32) de la couche isolante (14) à tester grâce à un signal électrique fourni entre des électrodes mises en contact avec la seconde face de la couche mince, l'une des électrodes (21,23) étant mise en contact avec ledit défaut majeur et l'autre électrode (22) étant mise en contact avec ladite zone (32) à tester.

2. Procédé selon la revendication 1, **caractérisé en ce que** ladite tension électrique est appliquée par l'intermédiaire de deux électrodes (21,23) mises en contact électrique avec la seconde face de la couche isolante (14), créant ainsi deux défauts majeurs dans la couche isolante, l'un de ces défauts majeurs ou les deux servant à application du test électrique.

3. Procédé selon l'une des revendications 1 ou 2, **caractérisé en ce que** ledit défaut majeur est crée dans une zone de forme annulaire centrée sur la zone de la couche isolante à tester.

4. Procédé selon l'une quelconque des revendications 1 à 3, **caractérisé en ce que** le test électrique consiste à appliquer une tension entre lesdites électrodes (21,22,23) et à relever le courant éventuel circulant entre lesdites électrodes.

5. Application du procédé selon l'une quelconque des revendications 1 à 4 à un substrat semi-conducteur comprenant une couche isolante enterrée (12) et une couche isolante superficielle (14) qui est la couche isolante à tester.

## Claims

1. Isolating layer characterization method (14) of which a first face covers and is in contact with a conductive or semi-conductive face of a substrate, the second face of the isolating layer (14) opposite the first face, being accessible electrically, the characterization consisting in verifying the quality of the electrical insulation presented by at least one first zone (32) of the isolating layer (14) by means of an electrical test, **characterised in that** it comprises the steps of:
- creation, by breakdown of the isolating layer by means of an electrical voltage or via the mechanical crossing of the isolating layer, of at least one major defect in a second zone (31, 33) of the isolating layer (14), the second zone being different from the first zone, this major defect forming a short-circuit located between the second face of the isolating layer and said conductive or semi-conductive face of the substrate,
- application of the electrical test to the zone (32) of the isolating layer (14) to be tested thanks to an electrical signal provided between electrodes placed into contact with the second face of the thin layer, one of the electrodes (21, 23) being placed into contact with said major defect and the other electrode (22) being placed into contact with said zone (32) to be tested.

2. Method according to claim 1, **characterised in that** the electrical voltage is applied by the intermediary of two electrodes (21, 23) placed into electrical contact with the second face of the isolating layer (14), as such creating two major defects in the isolating layer, with one of these major defects or both serving for the application of the electrical test.

3. Method according to one of claims 1 or 2, **characterised in that** said major defect is created in a zone of annular shape centred on the zone of the isolating layer to be tested.

4. Method according to any of claims 1 to 3, **characterised in that** the electrical test consists in applying a voltage between said electrodes (21, 22, 23) and in reading the current possibly circulating between said electrodes.

5. Application of the method according to any of claims 1 to 4 to a semiconductor substrate comprising a buried isolating layer (12) and a superficial isolating layer (14) which is the isolating layer to be tested.

## Patentansprüche

1. Verfahren zur Charakterisierung einer Isolierschicht (14), wobei eine erste Fläche derselben eine leitende oder halbleitende Fläche eines Substrats bedeckt und mit dieser in Kontakt ist und die der ersten Fläche entgegengesetzte zweite Fläche der Isolierschicht (14) elektrisch zugänglich ist, wobei die Charakterisierung darin besteht, die über mindestens eine erste Zone (32) der Isolierschicht (14) gezeigte Qualität der elektrischen Isolierung mittels eines elektrischen Tests zu verifizieren,
**dadurch gekennzeichnet, dass** das Verfahren die folgenden Stufen umfasst:
- Erzeugen von mindestens einem größeren Defekt in einer zweiten Zone (31, 33) der Isolierschicht (14) durch einen Durchschlag durch die Isolierschicht mittels einer elektrischen Spannung oder durch ein mechanisches Durchbrechen der Isolierschicht, wobei die zweite Zone von der ersten Zone verschieden ist, wobei dieser größere Defekt einen Kurzschluss bildet, der zwischen der zweiten Fläche der Isolierschicht und der leitenden oder halbleitenden Fläche des Substrats lokalisiert ist,
- Anwenden des elektrischen Tests auf die zu testende Zone (32) der Isolierschicht (14) mit einem elektrischen Signal, das zwischen Elektroden, die mit der zweiten Fläche der Dünnschicht in Kontakt stehen, geliefert wird, wobei eine der Elektroden (21, 23) mit dem größeren Defekt in Kontakt steht und die andere Elektrode (22) mit der zu testenden Zone (32) in Kontakt steht.

2. Verfahren nach Anspruch 1, **dadurch gekennzeichnet, dass** die elektrische Spannung über zwei Elektroden (21, 23), die mit der zweiten Fläche der Isolierschicht (14) in elektrischem Kontakt stehen, angelegt wird, sodass in der Isolierschicht zwei größere Defekte erzeugt werden, wobei einer dieser größeren Defekte oder beide zur Anwendung des elektrischen Tests dienen.

3. Verfahren nach einem der Ansprüche 1 oder 2, **dadurch** gekenntzeichnet, dass der größere Defekt in einer ringförmigen Zone, die an der zu testenden Zone der Isolierschicht zentriert ist, erzeugt wird.

4. Verfahren nach einem der Ansprüche 1 bis 3, **dadurch gekennzeichnet, dass** der elektrische Test darin besteht, eine Spannung zwischen den Elektroden (21, 22, 23) anzulegen und den möglichen, zwischen den Elektroden fließenden Strom zu bestimmen.

5. Anwendung des Verfahrens nach einem der Ansprüche 1 bis 4 auf ein Halbleitersubstrat, das eine vergrabene Isolierschicht (12) und eine Oberflächen-Isolierschicht (14), die die zu testende Isolierschicht ist, umfasst.
